# DEMANDE DE BREVET EUROPEEN

(11) **EP 0 567 403 A1**
(43) Date de publication de la demande: **27.10.1993**
(21) Numéro de dépôt: 93401039.8
(22) Date de dépôt: 21.04.1993
(51) Int. Cl.: H05K 5/00

(54) **Platine de servitude pour la commande et/ou l'alimentation d'organes électriques de véhicules**

(30) Priorité: 22.04.1992 FR 9204919
(71) Demandeur: VALEO ELECTRONIQUE, 94042 Creteil Cédex (FR)
(72) Inventeur: Boucheron, Jean-Louis, F-77176 Savigny-le-Temple (FR)
(74) Mandataire: Gamonal, Didier

(57) **Abrégé**

La présente invention concerne une platine de servitude pour la commande et/ou l'alimentation d'organes électriques de véhicules.

La platine est dotée de modules amovibles (161, 162, 163) montés sur une platine proprement dite et qui sont reliés au moins au point de vue électrique par des moyens de laison (163, 164) de façon à permettre une conception modulaire de l'alimentation des organes électriques de véhicules, sans rester lié à un véhicule particulier.

## Description

La présente invention concerne une platine de servitude pour la commande et/ou l'alimentation d'organes électriques de véhicules, et plus particulièrement elle concerne un concept de regroupement de fonctions intégrant les dispositifs de protection, de raccordement et de distribution dans le but de constituer sous forme modulaire un calculateur d'habitacle.

La platine de servitude de l'invention est disposée entre une source d'énergie électrique et une source de signaux de commande d'une part, et les organes électriques d'autre part.

Dans l'art antérieur, on a déjà proposé des dispositifs permettant de répartir l'énergie électrique provenant d'une source d'alimentation vers des charges en fonction de commande. Mais les dispositifs de l'art antérieur présentent un certain nombre d'inconvénients que la présente invention propose de surmonter.

Dans les dispositifs d'alimentation de véhicules de l'art antérieur, le nombre de fils d'alimentation et de commande est élevé ce qui augmente considérablement et le coût de la partie électrique du véhicule et la complexité technique de cette alimentation.

D'autre part, les dispositifs de l'art antérieur exigent une parfaite adéquation avec les organes électriques du véhicule sur lequel ils sont installés. De ce fait, les dispositifs d'alimentation de l'art antérieur sont en général prévus pour un seul type de véhicule. En particulier, il est souvent nécessaire de réétudier une grande partie de l'alimentation électrique même pour un véhicule d'un type donné mais dont les options d'équipement sont légèrement différentes du véhicule de base.

D'autre part, les dispositifs d'alimentation électriques de véhicules de l'art antérieur comportent, à partir d'une platine de servitude, un certain nombre de composants embrochables, et dont la répartition sur le dispositif exige un grand nombre de connexions. Or l'augmentation du nombre de connexions est une cause importante du coût du dispositif ainsi que de la réduction de sa fiabilité.

Dans le document EP-A-0 181 534, on décrit un dispositif qui comporte une unité électrique centrale pour la connexion centralisée de composants électriques tels que des tresses de câbles, des connecteurs embrochables, des fusibles et des interrupteurs, genre relais, qui sont reliés par des couches de connexion.

Mais la distribution de l'alimentation ou l'interconnexion entre des modules spécifiques liés à une platine de servitude n'est pas rendue possible.

La présente invention apporte un remède à ces inconvénients de l'art antérieur.

En effet, la présente invention concerne une platine de servitude pour la commande et/ou l'alimentation d'organes électriques de véhicules, disposée entre au moins une source d'alimentation électrique et une source de signaux de commande d'une part, et lesdits organes électriques d'autre part. La platine de servitude comporte un support à l'intérieur duquel est disposée au moins une couche de moyens de connexion sur au moins une couche desquelles est disposée une partie électronique qui intègre les dispositifs de protection, les circuits de puissance et de contrôle des organes électriques de manière à constituer un calculateur d'habitacle de véhicule.

La platine de servitude comporte au moins un module enfichable sur une face dudit support, et qui contient un dispositif électrique associé à la commande et/ou à l'alimentation d'au moins un organe électrique d'un véhicule donné.

L'invention se caractérise en ce que la platine de servitude comporte aussi un moyen de distribution de l'alimentation électrique et/ou d'interconnexion entre deux modules enfichables.

D'autres caractéristiques et avantages de la présente invention seront mieux compris à l'aide de la description et des figures annexées qui sont :
- les figures 1 et 2 : des exemples de réalisation de dispositifs d'alimentation selon l'art antérieur ;
- la figure 3 : le schéma d'une platine de servitude selon un mode de réalisation de l'état de la technique ;
- les figures 4 et 5 : deux modes de réalisation d'une platine de servitude selon la présente invention ;
- la figure 6 : un premier mode de réalisation d'une platine de servitude selon la présente invention ;
- la figure 7 : un autre mode de réalisation de la présente invention ;
- la figure 8 : un autre mode de réalisation de la présente invention comportant au moins deux modules distincts ;
- la figure 9 : un autre mode de réalisation à une seule couche d'interconnexion sans connexion externe ;
- la figure 10 : un autre mode de réalisation d'une platine de servitude selon l'invention avec deux couches sans connexion externe ;
- la figure 11 : un autre mode de réalisation d'une platine de servitude selon l'invention représentée en partie avec deux couches et des connexions externes ;
- la figure 12: un détail d'un mode de réalisation partiel d'un module amovible selon l'invention ;
- les figures 13 et 14 : un autre mode de réalisation d'une platine de servitude selon l'invention comportant des moyens de raccordement selon une variante ;
- les figures 15 et 16 : des schémas d'un exemple d'application du concept de l'invention ;
- les figures 17 et 18 : des schémas d'un autre exemple d'application du concept de l'invention.

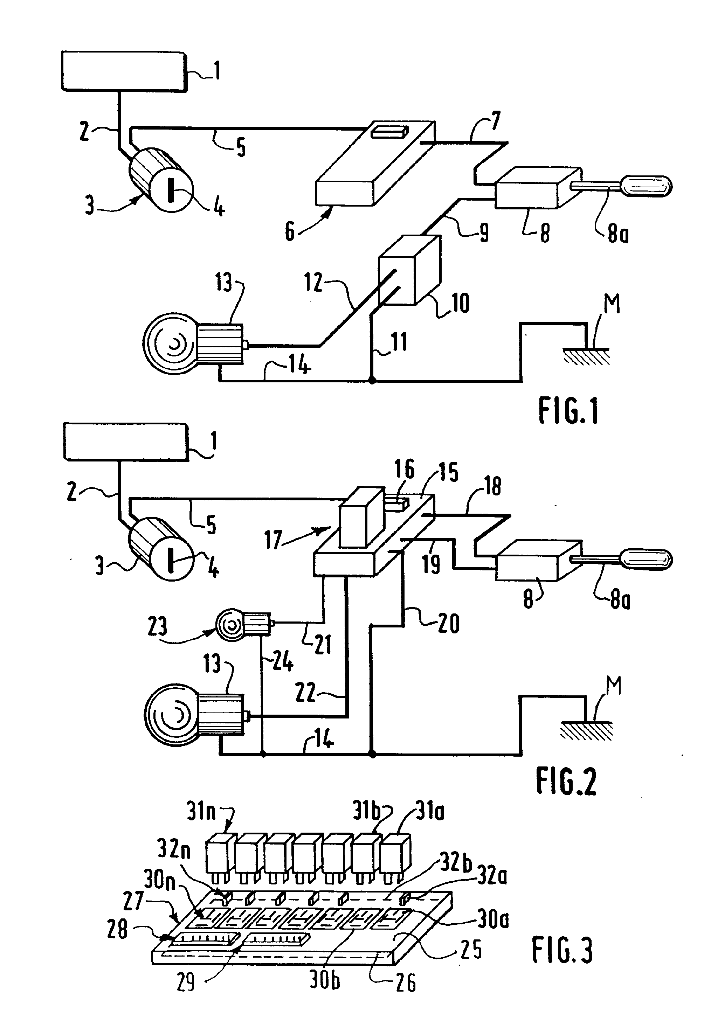

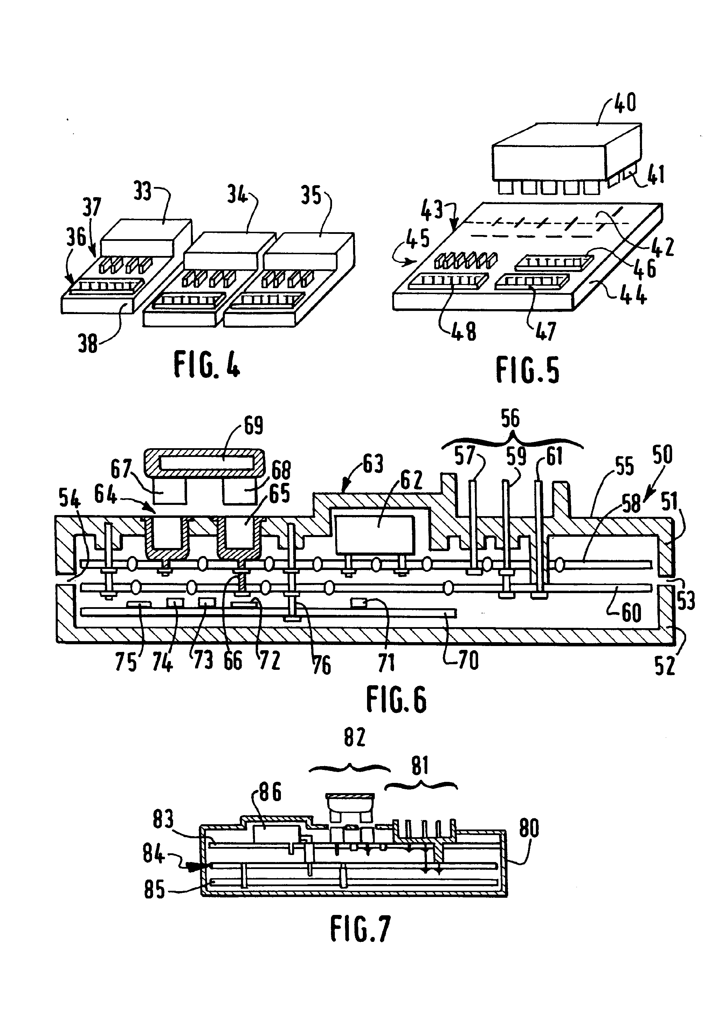

A la figure 1, on a représenté un premier mode de réalisation d'un dispositif d'alimentation de véhicule selon l'état de la technique.

Le dispositif d'alimentation de la figure 1 comporte un bloc d'alimentation 1 constitué par une batterie et un alternateur qui lui est connecté embarqués à bord du véhicule. La sortie du bloc d'alimentation est transmise à un module de sélection 3 sur lequel on dispose des moyens 4 comme un antivol et/ ou une clé d'allumage de véhicule.

En sortie du module de sélection 3, on trouve un fil 5 de sélection de la fonction d'alimentation. Le fil 5 est connecté à un dispositif de protection 6 qui comporte principalement une pluralité de fusibles ou de dispositifs du même genre de protection contre les surtensions et/ ou les surintensités.

La sortie du module 6 est transmise par un canal 7 à un dispositif de commande 8 qui reçoit, par un moyen de saisie de commande 8a, une commande par exemple produite par le conducteur du véhicule depuis le tableau de bord.

Le dispositif de commande 8 comporte un fil de sortie 9, qui est transmis à un boîtier électronique 10 de gestion électrique de l'énergie.

Le boîtier électronique 10 est connecté par un fil 11 à la masse M du véhicule d'une part et par un canal de sortie 12 à une charge 13 constituée par un organe électrique de véhicule comme une lampe d'éclairage. La charge 13 est d'autre part connectée par un fil 14 à la masse M.

Dans cet état de la technique, le nombre de composants séparés par des canaux de communication ou de transport d'énergie est considérable et le coût de fabrication est de ce fait élevé, tandis que la fiabilité de l'ensemble est faible.

Afin de porter remède quelque peu à cet état de la technique, on a déjà proposé de regrouper le boîtier électronique 10 sur le module de protection 6.

A la figure 2, les mêmes éléments que ceux de la figure 1 portent les mêmes numéros de référence et ne sont pas décrits plus en détail. Le module intégré 15 comporte d'une part les protections 16 constituées par exemple par des fusibles et d'autre part un boîtier électronique 17 analogue au boîtier 10 de la figure 1.

Le boîtier 15 reçoit les entrées respectivement 18 et 19 provenant du dispositif de commande 8 activé par un moyen de saisie de commande 8a. Il est aussi connecté par un canal 20 à la masse M et produit par un fil de sortie 22 une distribution de puissance vers la charge 13. D'autre part, par un fil 21 il permet d'activer un moyen d'avertissement 23 comme une lampe de diagnostic. La lampe de diagnostic est connectée par un fil 24 à la masse.

Ce regroupement de fonctions a éliminé les liaisons de type 9 entre l'électronique et la commande comme c'était le cas dans le mode de réalisation de la figure 1.

A la figure 3, on a représenté un mode de réalisation dans lequel dans l'art antérieur, on a déjà proposé de regrouper l'ensemble des dispositifs, comme les dispositifs 15, 16, 17 de la figure 2, sur une platine de servitude. La platine de servitude comporte un boîtier 25 réalisé en un matériau plastique par exemple en deux moitiés supérieure et inférieure à l'intérieur duquel on a disposé au moins une couche 26 de raccordement, représentée en tirets à la figure 3. Sur la face supérieure 27 de la platine de servitude 25, on a disposé des zones de connexion respectivement 28 pour l'alimentation électrique et 29 pour le raccordement aux organes électriques.

D'autre part, la face supérieure 27 de la platine de servitude 25 comporte une pluralité de zones de raccordement 30a, 30b, ..., 30n sur lesquelles on vient embrocher des boîtiers électroniques ou des relais respectivement 31 a, 31 b, ..., 31 n. De même, on dispose une pluralité de fusibles dans les zones 30a à 30n et qui sont référencés 32a, 32b, ..., 32n.

Cette présentation compacte présente l'avantage que l'ensemble des boîtiers de protection et de gestion électronique est rassemblé sur un seul circuit et dans un seul endroit, ce qui permet de disposer d'un seul endroit accessible pour effectuer Ika maintenance (fusible coupé, relais embrochable ou boîtier électronique à changer).

Cependant, les boîtiers embrochables 31a, 31 b, .... 31 n représentent des condensateurs, des transistors, des résistances, etc .... Ils sont destinés à exécuter chacun une simple fonction électrique dont la composition est exécutée selon des schémas électroniques prédéterminés, implémentés grâce à des pistes conductrices sur lesquelles les boîtiers sont enfichés, et qui sont disposées sur la couche de connexion 26, à raison de un schéma électronique pour chacun des organes électriques connectés par l'intermédiaire du connecteur 29. La couche de connexion 26 interne ne réalise qu'un schéma électrique propre à disposer des réseaux de distribution incluant les dispositifs de protection et les interconnexions désirées. Cette conception exige à revoir notamment la couche de connexion 26 à chaque fois qu'une modification doit être faite sur le véhicule.

D'autre part, il existe encore un grand nombre de connexions qui permettent de raccorder les organes électriques à la platine de servitude.

A la figure 4, on a représenté un premier moyen selon l'invention pour porter remède à cet inconvénient de l'état de la technique.

On décide de regrouper dans des modules 33, 34, 35, ... un certain nombre de fonctions électriques et électroniques d'alimentation et/ou de commande :
- ou bien en fonction d'impératifs électriques ou électroniques liés à l'exécution des schémas électriques ;
- ou bien en fonction d'organes électriques ou de groupe d'organes électriques liés à un véhicule.

En règle générale, le concept d'architecture de l'invention tend à optimiser un groupe de fonctions pour minimiser les interconnexions extérieures. En particulier, les modules 33 à 35 sont destinés à venir s'embrocher sur des zones semblables aux zones 30a à 30n de la figure 3, mais comportent chacun l'ensemble des fonctions électroniques, électriques et de protection destinées à assurer la liaison à un groupe d'organes électriques ou à au moins un organe électrique d'un véhicule donné.

Quand la pluralité d'organes électriques ou l'organe électrique change dans un véhicule donné, il suffit de changer le module concerné 33, 34 ou 35. De même en cas de défaillance, il suffit de retirer le module défaillant de façon à réaliser la réparation.

Enfin, il est possible d'associer un module, non plus à un véhicule d'un type donné comme c'était le cas dans l'art antérieur, mais à un type d'organe électrique destiné à équiper plusieurs véhicules de marques ou de types différents.

Chaque module comme le module 33 comporte un connecteur 36 qui permet le raccordement, d'une part à la charge électrique, d'autre part à l'alimentation électrique. Il comporte aussi une pluralité de fusibles 37 enfichés sur une face supérieure 38 du module. Enfin à l'intérieur du module 33, ainsi qu'on le représentera plus loin, on dispose l'électronique nécessaire à la réalisation des fonctions de commande et/ou d'alimentation précitées.

A la figure 5, on a représenté un autre mode de réalisation selon l'invention. Dans ce type de réalisation, l'ensemble des fonctions électroniques est regroupé dans un module enfichable unique 40 doté de pattes de connexion, comme la patte 41, et qui viennent s'embrocher dans une zone de connexion 42 sur la face supérieure 43 d'une platine de servitude 44. La platine de servitude comporte un support 44 à l'intérieur duquel est disposé un certain nombre de couches de raccordement (non représentées), qui reçoivent d'une part les pattes comme les pattes 41 du module électronique 40, les pattes de connexion de fusibles 45 ainsi que les bornes des connexions électroniques ou électriques d'une part à l'alimentation par le connecteur 46, et d'autre part à des charges par les connecteurs 47 et 48.

Dans le cas de la conception modulaire de la figure 4, on peut réaliser une optimisation de chaque module en fonction :
- des besoins exprimés par les niveaux d'équipement requis pour chaque véhicule ou chaque type de véhicule ;
- des objectifs de coût et de fiabilité compatibles avec les impératifs de fonctionnement d'une part et de coût d'autre part.

A la figure 6, on a représenté un premier mode de réalisation d'une platine de servitude dans laquelle on a intégré de l'électronique de manière non amovible.

La platine de servitude 50 est constituée d'un support composé en deux moitiés : respectivement, une moitié supérieure 51 et une moitié inférieure 52, connectées entre elles par un moyen de liaison (non représenté) comme par exemple un système à vis et joint, entre les bords de séparation 53 et 54.

La face supérieure 55 du support 51-54 comporte au moins un connecteur comme le connecteur de raccordement 56 qui présente des traversées comme les traversées conductrices 57, connectées à une première couche de connexion 58, les traversées 59, connectées simultanément à la première couche de connexion 58 et à une seconde couche de connexion 60 et les traversées 61, connectées seulement à la seconde couche de connexion 60, et qui sont isolées au passage de la première couche 58, par exemple pour constituer un plan de masse.

Selon l'invention, on dispose sur une première couche de raccordement 58 un module 62 dans lequel est intégré l'ensemble des circuits de puissance permettant de gérer l'alimentation de la platine de servitude ou qui permettent de contrôler le courant consommé (shunts).

Ce dispositif intégré peut être muni (non représenté) d'un radiateur qui, par exemple, pourrait déboucher sur la face supérieure 55 dans la zone en surélévation 63.

D'autre part, la face supérieure 55 comporte deux clips femelles de connexion, respectivement 64 et 65 connectées par des traversées respectivement au plan de masse 60 par une traversée 66 et directement à la couche 58 de puissance. On embroche par des pattes respectivement 67 et 68 un fusible 69 dans les clips 64 et 65 de façon à réaliser les protections. Il est entendu que la platine de la figure 6 comporte une pluralité de tels dispositifs 64-69.

D'autre part, le module de l'invention comporte une troisième couche 70 qui porte, de manière classique, ainsi qu'on sait le réaliser dans l'état de la technique, une pluralité de composants électroniques comme les composants 71, 72, 73, 74 et 75 de façon à constituer le regroupement des fonctions électroniques éxécutées par le module ainsi constitué et embroché sur la platine de servitude. Une traversée conductrice 76 permet de relier électriquement les trois couches 70,60 et 58, d'autres connexions étant prévues et permettant de ne relier qu'un nombre limité de couches selon les besoins liés à l'application envisagée.

Le composant de puissance 62 d'alimentation doit prendre en compte les différents niveaux d'alimentation disponibles sur le véhicule. D'autre part les protections comme le fusible 69 peuvent être intégrées dans l'intérieur du boîtier tout en restant accessibles pour les remplacements.

D'autre part, les fonctions électroniques sont regroupées et intégrées sur au moins une couche interne de la platine de servitude. Les commandes peuvent être à faible pouvoir de coupure si la commande de puissance est relayée. Les commandes sont alors transmises en faible courant sur le connecteur 56.

Enfin, le dispositif de la figure 6 peut comporter des moyens de diagnostic pour prendre en compte le diagnostic des fonctions contrôlées et ce diagnostic peut être globalisé.

A la figure 7, on a représenté un second mode de réalisation selon l'invention. A la figure 7, on a représenté un module destiné à venir se placer sur une platine de support ayant un rôle seulement mécanique des modules embrochés et éventuellement thermique. Le module comporte un boîtier 80 muni d'un connecteur 81 analogue au connecteur 56 décrit à la figure 6, une série de moyens de protection 82 analogue au fusible 69 de la figure 6 et trois couches de connexion internes respectivement, 83 destinée à gérer la puissance, 84 une couche de distribution de puissance, destinée à réaliser un plan de connexion, et 85 sur laquelle l'électronique est intégrée. On a représenté aussi un module intégré de gestion de puissance 86 connecté sur la couche 83. Le composant 86 est un transistor ou un composant de puissance intelligent utilisant une partie de la première couche pour réaliser les connexions de puissance et servir de refroidisseur et une partie de la seconde couche pour raccorder les commandes.

Cette conception modulaire permet l'intégration des circuits électroniques traditionnellement séparés. De plus, elle permet l'utilisation d'un coeur électronique commun.

Cette conception modulaire permet aussi de concevoir chaque sous-ensemble sous forme d'une station qui soit compatible avec le multiplexage.

Le dispositif de protection 86 est aussi connecté à des fusibles 82 de protection classique ou à d'autres dispositifs de protection contre les surtensions. Il est ainsi connecté à des composants de puissance qui permettent de protéger ses sorties contre les surtensions et/ou les surintensités.

La couche de distribution de puissance 84 permet de gérer le besoin en raccordements d'une part de puissance et d'autre part de faible niveau. Les raccordements de puissance sont faits d'une part en entrée vers les alimentations comme la batterie d'une part et d'autre part en sortie vers les charges constituées par les organes électriques de véhicules. Les raccordements de faibles niveaux sont faits d'une part en entrée des signaux de commande provenant des dispositifs de commande comme le tableau de bord et d'autre part en sortie des signaux de commande destinés à gérer les charges électriques.

La couche électronique comme la couche 85 qui porte le coeur électronique du module permet de répondre d'une part au besoin en commandes de puissance. Elle réalise les contrôles et les détections sur la platine de servitude. Elle assure enfin la fonction de communication entre le tableau de bord d'une part et les différents organes du véhicule. Elle réalise un certain nombre de fonctions intégrées comme la gestion des temporisations. Enfin, elle exécute toutes les logiques de commandes permettant de calculer des états logiques.

Le connecteur d'alimentation, comme le connecteur 81 de la figure 7 ou 56 de la figure 6, porte les polarités de la borne positive de la batterie du + ACC, du + APC, du + démarreur, du + lanterne etc.

Pour la partie puissance, on peut utiliser le couplage d'une mesure du courant d'une part avec le relayage par des relais de puissance qu'ils soient de types électromagnétique ou statique.

D'autre part, le module de l'invention comporte, parmi sa connectique, des connecteurs permettant l'interconnexion et les commandes. Ainsi, on a les liaisons de signaux, les interconnexions avec d'autres boîtiers et témoins de fonctionnement.

Dans une conception modulaire selon l'invention, il faut alimenter chaque module, le doter de son électronique nécessaire qui est d'un type différent pour chaque module normalement, et il faut réaliser des sorties de connexion entre modules. En contrepartie, on peut adapter la platine de servitude aux différents niveaux d'équipement. D'autre part, on obtient une bonne fiabilité avec une puissance intégrée par répartition sur plusieurs modules. L'implémentation est donc plus facile. Il y a ainsi la possibilité d'utilisation des modules pour d'autres véhicules.

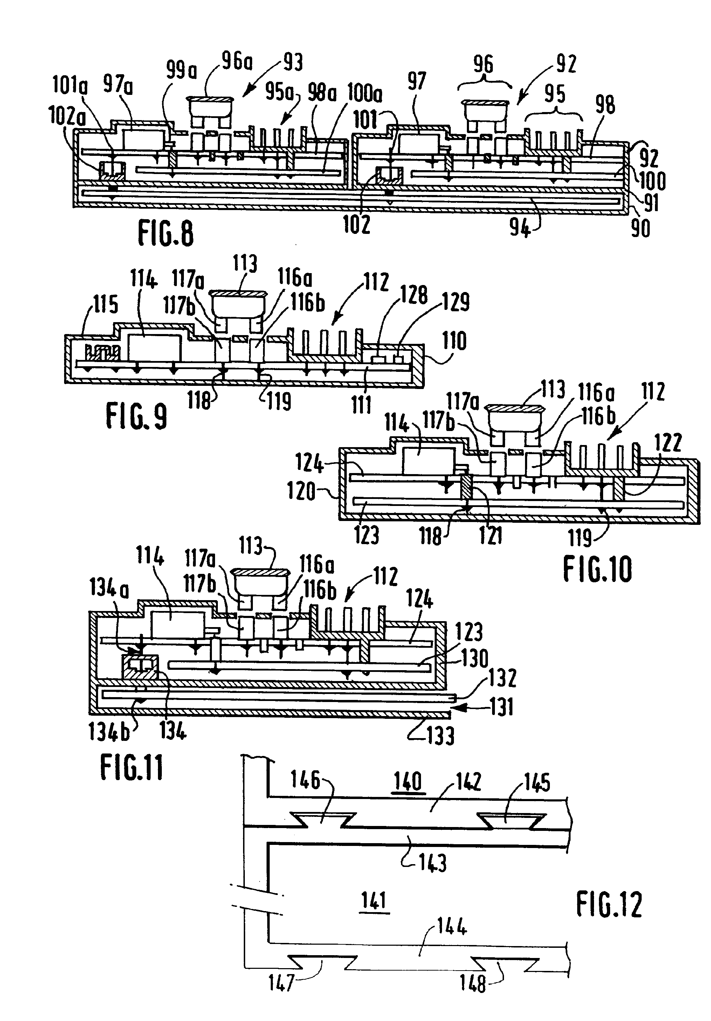

A la figure 8, on a représenté un mode de réalisation d'une platine selon l'invention. La platine comporte un support 90 constitué par un boîtier plastique, par exemple sur la face supérieure 91 duquel on vient fixer des modules respectivement 92 et 93.

Le support 90 comporte une couche unique 94 de distribution de la puissance d'alimentation et de gestion des interconnexions entre modules. Cette couche d'interconnexion permet d'échanger des signaux et de l'énergie entre deux modules 92 et 93. A la figure 8, on a réalisé des modules à deux couches. Les modules comportent principalement une zone de connexion 95, un moyen de protection contre les surtensions et les surcourants 96, ainsi qu'un circuit électronique intégré de gestion des puissances 97. Le circuit de puissance est connecté sur une couche 98 ainsi que, par ses sorties intégrées 99, sur une couche 100 portant l'électronique du module 92. D'autre part, la couche de connexion 98 porte une traversée 101. La traversée conductrice 101 présente une première extrémité qui est rendue solidaire de la couche de connexion 98, par exemple par soudage sur une piste conductrice de celle-ci, un corps allongé qui traverse un organe de passage étanche 102 et une seconde extrémité qui vient se loger dans un clips femelle implanté sur une partie conductrice sur la couche de connexion 94 à travers la face supérieure 91 du support 90 de la platine de servitude. On a de ce fait constitué un moyen de liaison par connexion embrochable permettant ainsi le montage et le démontage des modules sur la platine de support 90, 91. Le module 93 voisin est en effet équipé des mêmes dispositifs qui ont été référencés avec les mêmes numéros suivis par la lettre a.

La platine à une seule couche de connexion permet l'adaptation aux différents niveaux d'équipement d'un même véhicule. Elle permet une implémentation aisée. Elle permet d'utiliser des modules pour d'autres véhicules. Enfin on dispose d'une bonne fiabilité avec une puissance intégrée. La platine de servitude permet de regrouper les alimentations. Les connexions inter-modules sont intégrées. Une électronique commune peut être regroupée sur la couche de raccordement 94 de la platine support.

Aux figures 9 à 11, on a représenté trois modes de réalisation de modules selon l'architecture d'intégration de l'invention, dans lesquelles les éléments identiques ou similaires portent les mêmes numéros de référence.

A la figure 9, le module comporte un boîtier 110 à l'intérieur duquel est logé une seule couche de connexion 11, sur laquelle se trouve les moyens de raccordement constitués principalement par des pistes conductrices, disposés sur un substrat isolant et conducteur de la chaleur.

Sur la face supérieure du module est disposé un connecteur 112 dont trois traversées conductrices connectent à la couche de connexion 111. La face supérieure comporte aussi l'insertion de deux contacts femelles 116b et 117b qui reçoivent les pattes de connexion 116a et 116b d'un fusible comme le fusible 113.

La couche de connexion porte aussi des circuits de puissance 114 et 115 et des composants comme les composants 128 et 129 destinés à constituer l'électronique intégrée du module.

A la figure 10, le boîtier 120 du module comporte deux couches de connexion respectivement 123 et 124.

Dans cette disposition, la couche 124 porte les circuits de puissance avec leurs radiateurs éventuels pour dégagement de la chaleur par rayonnement sur la face supérieure libre du boîtier 120, tandis que la couche 123 porte les circuits logiques et les composants de faible puissance. La situation est inversée si les composants de puissance comportent des radiateurs de convexion, destinés à venir se coupler au point de vue thermique avec par exemple le châssis du véhicule, qui sert de thermostat.

A la figure 11, on a représenté un module sur une partie d'une platine de servitude qui comporte un fond 133 et un logement 131 dans lequel est disposé une couche de connexion 132 qui permet de réaliser les connexions externes entre les modules disposés sur la platine.

Dans ce cas, chaque module comme le module 130 comporte un moyen d'encliquetage 134 sur la face supérieure de la platine 131 - 133 qui est munie d'une pluralité de traversées conductrices comme la traverse 134a dont l'extrémité 134b vient en contact avec une zone conductrice de la couche de connexion 132.

A la figure 12, on a représenté un mode de réalisation des parois latérales des modules destiné à favoriser et à aider leur insertion à plusieurs sur la même platine.

Deux modules 140 et 141 sont vus de dessus en coupe et partiellement et présentent respectivement des parois latérales 142 et 143 en contact quand les modules sont installés convenablement sur la face supérieure de la platine de servitude. la face 142 présente des logements de guidage et de fixation dans lesquels s'introduisent des languettes correspondantes 146 et 145 portées par la paroi correspondante 143.

L'autre face 144 du module 141 qui n'est pas en contact avec un autre module, si le module est en bout de rangée, comporte des logements de guidage 147 et 148.

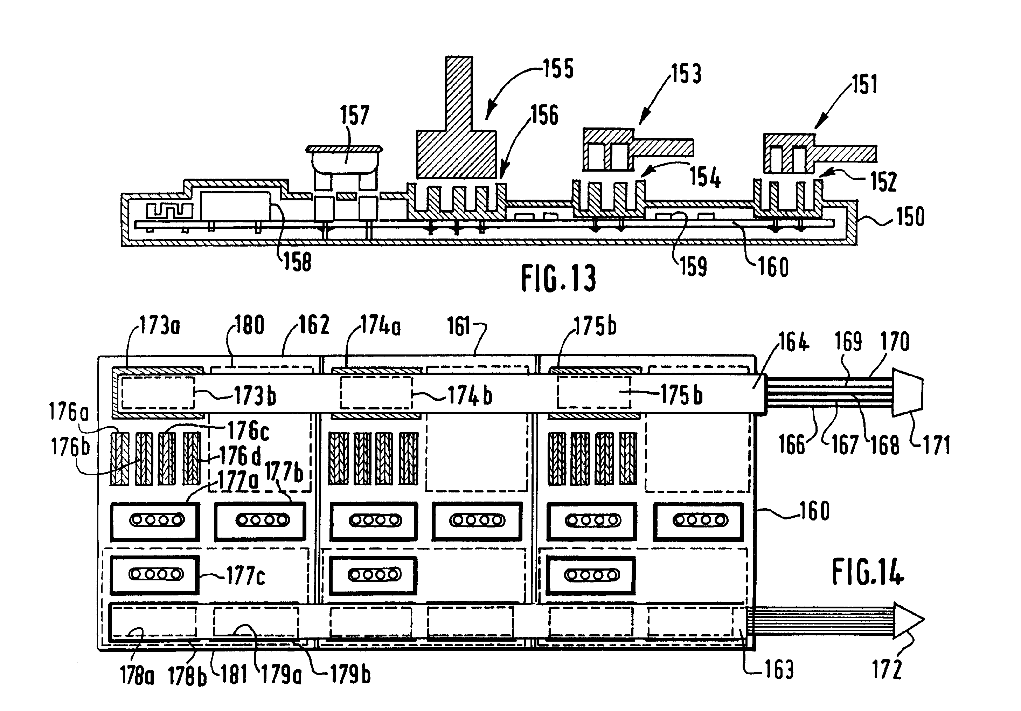

A la figure 13, on a représenté un mode de réalisation d'un module 150 à une seule couche de connexion 160. Le module comporte sur sa face supérieure trois connecteurs 152, 154 et 156, dévolus respectivement :
- à l'électronique de commande et d'interconnexion entre modules, qui regroupe en fait la partie signal des transmissions ;
- à l'alimentation électrique ; et
- à la distribution de puissance vers les charges électriques.

La couche de connexion 160 est connectée par des traverses conductrices aux connecteurs, qui sont raccordés à des faisceaux de conducteurs adaptés sur des broches respectivement 151, 153 et 154.

Dans un mode de réalisation, la couche de connexion porte les composants électroniques de puissance comme le circuit 158 et de traitement comme le composant 159. Sur la face supérieure du module sont aussi disposés des fusibles comme le fusible 157.

Dans un mode de réalisation avantageux, au moins deux des trois connecteurs 151, 153 et 155 sont constitués sous formes de barres rigides de façon à regrouper les fils de liaison d'une part et à assembler par l'insertion des barres sur les connecteurs réciproques 152, 154 ou 156 les différents modules entre eux, en particulier, si les modules présentent des parois latérales comme dans le cas de la figure 12.

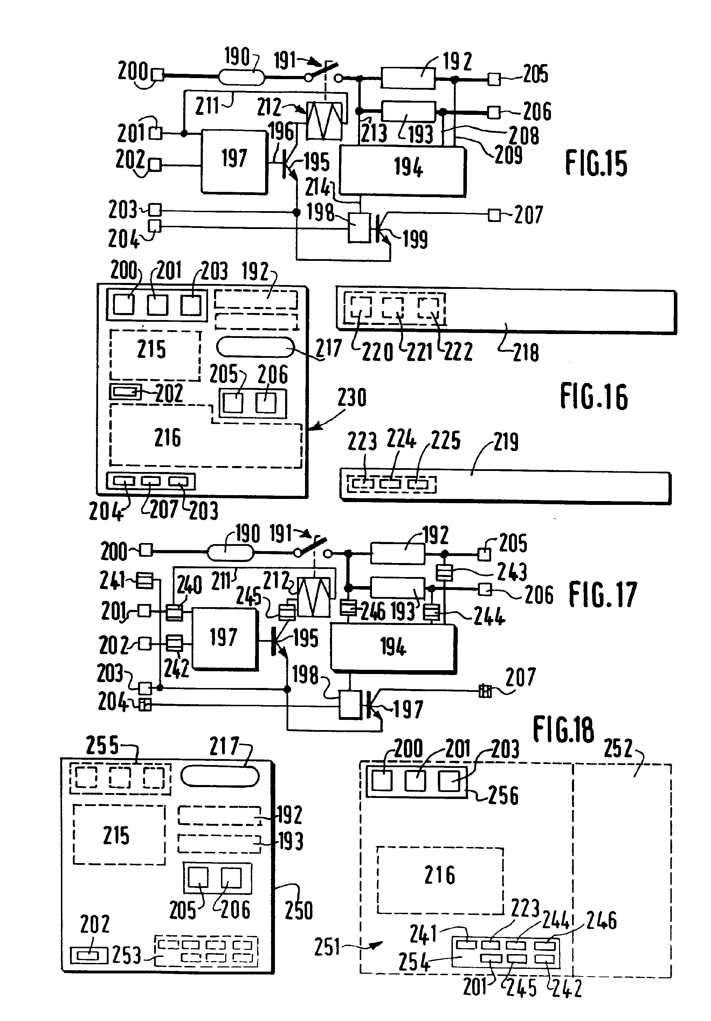

A la figure 14, on a représenté une vue de dessus dans laquelle trois modules respectivement 160, 161 et 162 sont associés par l'intermédiaire de deux barres de liaisons électrique et mécanique respectivement 163 et 164.

La barre de liaison 164 est dévolue à la connexion des alimentations électriques des modules. Elle comporte donc des fils électriques 166 à 170 qui transportent les masses et les différentes polarités électriques nécessaires, comme le plus de la batterie, ou le plus après contact, etc.

La barre de liaison est disposée au-dessus des trois modules représentés à la figure 14, respectivement 160, 161 et 162. Ces modules peuvent être ou non montés sur une platine, disposés sous les modules dont le seul rôle sera un rôle de laison mécanique et éventuellement thermique d'évacuation des puissances thermiques dissipées. La platine porte alors des moyens de liaison mécanique aux modules, ainsi que des moyens de couplage thermique aux composants générateurs de chaleur intégrés dans chaque module.

Dans un autre mode de réalisation, la barre de liaison est constituée en un matériau rigide et est constituée sous la forme d'une cornière rigide par exemple de section en forme de "C", et qui vient en liaison avec des parties en "U", par exemple pour encliquetage sur la face supérieure de chaque module 160 à 162.

Chaque module 160 à 162 porte un connecteur 173a, 174a, et 175a dans une zone prédéterminée de la surface supérieure accessible du module. En positions correspondantes, la barre de liaison 164 porte des connecteurs correspondants 173b, 174b, 175b qui viennent se monter dans leurs connecteurs respectifs 173a, 174a, et 175a.

La face supérieure de chaque module porte aussi une pluralité de fusibles 176a, 176b, 176c, 176d. Les dessins semblables dans les trois modules ne sont ni référencés ni décrits pour chacun d'eux.

La face supérieure de chaque module comporte aussi des connecteurs 177a, 177b, 177c de raccordement du module à chacune des charges électriques ou groupe de charges électriques qu'il est chargé d'alimenter et de commander.

Dans la partie basse du dessin, chaque module comporte deux connecteurs 178a et 179a de liaison avec la barre de connexion 163. La barre de liaison comporte en des endroits correspondants des connecteurs correspondants, respectivement 178b et 179b. La barre de liaison 163 comporte une pluralité de fils de liaisons électriques de faibles niveaux (partie logique) de façon à constituer une interconnexion entre modules et avec (172) des organes électriques pilotables directement avec de petits niveaux.

A l'intérieur de chaque module, selon au moins l'un des modes de réalisation précités, on trouve au moins une couche de connexion qui comporte un coeur électronique. En particulier, on trouve une partie 180 de relayage et de circuiterie de puissance qui comporte des relais électromagnétiques et/ ou des transistors de puissance de type MOS notamment, ou encore des composants de puisance intelligents. On trouve ensuite une partie logique 181 qui comporte les composants électroniques de petits signaux qui exécute les traitements des signaux logiques principalement.

Aux figures 15 et 16, on a représenté un premier exemple d'application du concept de l'invention. Aux figures, les éléments correspondants de la figure 15 qui est un schéma électronique et de la figure 16 qui est une vue schématique de dessus du module selon l'invention qui implémente le schéma portent les mêmes numéros de référence.

L'entrée 200 est connectée à la borne positive dite "+ batterie" et est connectée à une première borne d'un dispositif de protection comme un fusible 190, dont l'autre borne est connectée à une première borne d'un relais de puissance, réalisé sous forme d'un relais électromagnétique comportant un contacteur 191 et une bobine 212. L'autre borne du relais est transmise aux entrées respectives de premier et second circuits 192 et 193 de mesure du courant traversant la ligne 200.

La borne d'entrée 201 est connectée à la borne d'alimentation dite "+ après contact" ou +ACC" en sortie du dispositif anti-vol (non représentée à la figure 15).

Cette polarité est communiquée d'une part à l'entrée de polarisation d'un circuit logique 197, implémenté dans la zone 216 du module de la figure 16, et d'autre part à une première borne de la bobine 212 par un fil 211. L'autre borne de la bobine 212 est connectée au collecteur d'un transistor de commande 195 dont l'émetteur est connecté à la masse 203 d'une part et à la première entrée d'une porte logique 198. La base du transistor de commande 195 est connectée en sortie du circuit logique 197.

Une borne d'entrée 202 du circuit logique 197 est connectée à un dispositif de commande non représenté, qui produit une forme d'onde quand une condition d'entrée est réalisée et qui demande le changement d'état du relais 191, 212.

L'autre borne de la porte logique 198 est connectée à une entrée 204 du schéma implémenté et qui reçoit un niveau logique haut H quand le dispositif de commande précité (non représenté) demande un test d'un voyant ou témoin, connectée sur une sortie 207 du schéma.

La borne 207 d'activation du témoin est polarisée en sortie sur le collecteur d'un second transistor de puissance 199 dont l'émetteur est aussi connecté à la masse 203 et dont la base est connectée à la sortie de la porte logique 198.

Quand la porte logique 198 est un OU, le témoin connecté à la borne de sortie 207 est allumé si le test de témoin est demandé d'une part, ou si une sortie 214 d'un circuit 194 de détection de défaillance qui est connectée à une seconde entrée de la porte OU 198 est à l'état actif haut, par exemple.

Le circuit de détection de défaillance 194 comporte trois entrées respectivement 213 connectée au point commun entre les premier et second circuits 192 et 193 de mesure de courant, 208 connectée à l'autre borne du circuit 193 et 209 connectée à l'autre borne du premier circuit 192 de mesure de courant.

Quand les deux valeurs de tension mesurées respectivement aux bornes 213 et 208 d'une part et aux bornes 213 et 209 d'autre part ne sont pas séparés d'une valeur prédéterminée, le circuit 194 de détection de défaillance produit une sortie 214 de niveau haut actif qui permet d'allumer le témoin connectée à la borne 207 précitée.

Le circuit de la figure 15 comporte aussi deux sorties 205 et 206 de puissance destinées à alimenter selon deux modes de courant un organe électrique donné.

A la figure 16, on a représenté l'implémentation du circuit de la figure 15 sur un module par exemple selon le mode de réalisation de la figure 14.

En particulier, la partie supérieure du module 230 comporte un connecteur dont les bornes sont repérées 200,201 et 203 selon la définition de la figure 15, et correspondent aux bornes correspondantes 220, 221 et 22 d'un connecteur prévu sur la barre d'alimentation 218, représentée avant son montage sur le module 230.

De même, le module 230 comporte des connecteurs séparés pour les bornes 202, 205 et 206 précitées, tandis que dans sa partie inférieure, le module 230 est muni d'un connecteur à trois broches respectivement 204, 207 et 203, qui correspondent aux broches d'un connecteur 223,224 et 225 sur la barre 219 d'interconnexion entre modules, représentée avant son montage sur le module 230.

Le fusible 197 de la figure 15 a été représenté en 217 à la figure 16, et la couche de connexions (non référencée au dessin) porte des zones 215 d'électronique de puissance 216 de traitement logique.

Aux figures 17 et 18, on a représenté des schémas d'un autre exemple d'application du concept de l'invention. A la figure 17, les éléments qui portent les mêmes numéros de référence que ceux des figures 15 et 16 ou de la figure 18 sont identiques ou semblables et ne seront pas plus décrits.

Dans le mode de réalisation des figures 17 et 18, on a construit une intégration selon deux blocs distincts, respectivement, un module 250 qui comporte la partie d'électronique de puissance 215 avec notamment les résistances de mesure de courant 192 et 193, et une platine de servitude 251,252 qui comporte au moins une couche de connexion qui porte des circuits électroniques 216 qui réalise la partie logique du schéma de la figure 17, et une partie 252 qui porte les circuits de contrôle réalisant le test du témoin et le témoin lui- même.

A cet effet, on a ajouté par rapport au schéma électrique de la figure 15, un certain nombre de bornes de connexion, respectivement :
- 240 et 242 de prélèvement de la tension dite de "+ après contact", et de condition d'entrée ;
- 241 de report de masse ;
- 243 et 244 de prélèvement des mesures d'intensités ;
- 245 de commande de la bobine du relais 191 ;
- 246 de référence de tension.

Quand on vient monter le module amovible 250 sur la face supérieure de la platine de servitude, des connecteurs 253 et 255 sous le module, viennent s'engager dans les connecteurs correspondants 254 et 256 sur la face supérieure de la platine de servitude. Il suffit ensuite de raccorder les connecteurs 202 d'une part et 205, 206 d'autre part pour terminer le montage de la platine.

Bien entendu, la présente invention ne se limite pas aux modes de réalisation décrits mais en comprend toutes les adaptations à la portée de l'homme de métier et celles définies selon les revendications annexées.

## Revendications

1. Platine de servitude pour la commande et/ou l'ali- i-mentation d'organes électriques de véhicules, disposée entre au moins une source d'alimentation électrique et une source de signaux de commande d'une part, et lesdits organes électriques d'autre part, la platine de servitude comportant un support à l'intérieur duquel est disposée au moins une couche de moyens de connexion sur au moins une couche desquelles est disposée une partie électronique qui intègre les dispositifs de protection, les circuits de puissance et de contrôle des organes électriques de manière à constituer un calculateur d'habitacle de véhicule, et pouvant comporter au moins un module enfichable sur une face dudit support, et qui contient un dispositif électrique associé à la commande et/ou à l'alimentation d'au moins un organe électrique d'un véhicule donné, caractérisée en ce qu'elle comporte un moyen de distribution de l'alimentation électrique et/ou d'interconnexion entre deux modules enfichables.

2. Platine selon la revendication 1, caractérisée en ce que le moyen de distribution est constitué à l'intérieur dudit support et comporte une pluralité de traverses conductrices connectées à au moins une couche de connexion dans ladite platine.

3. Platine selon la revendication 1, caractérisée en ce que le moyen de distribution comporte au moins une barre de liaison comportant une pluralité de fils de liaison, connectés à au moins un connecteur qui s'engage dans un connecteur correspondant du module correspondant, et en ce que la barre est constituée par une plaque de section en forme de "C" de façon à constituer un moyen de liaison mécanique et/ou électrique entre deux modules.

4. Platine selon l'une des revendications précédentes, caractérisée en ce que chaque module et/ou platine comporte une seule couche (11) de connexion qui porte les composants électroniques de puissance (114) et/ou de logique (128,129).

5. Platine selon l'une des revendications 1 à 3, caractérisée en ce que chaque module et/ou la platine comporte une première couche de connexion (100) qui porte les composants électroniques de logique et les connexions, et une seconde couche (98) qui porte les composants de puissance et les protections.

6. Platine selon la revendication 5, caractérisée en ce que la platine comporte un fond (90) qui comporte une couche de connexion, sur laquelle sont enfichés des modules enfichables (92,93,...) qui y sont interconnectés par des moyens de fixation (102, 102a,...) comportant des traverses conductrices.

7. Platine selon l'une des revendications 1 à 3, caractérisée en ce que chaque module et/ou la platine comporte une première couche de connexion (60), une seconde couche (58) portant les composants de puissance (62) et une troisième couche (70) portant les composants logiques (73 - 76).

8. Platine selon l'une des revendications précédentes, caractérisée en ce que les modules amovibles comportent des moyens de guidage latéral ((145 - 148) pour être montés les uns à côté des autres sur la face supérieure d'une platine.
